# EUROPÄISCHE PATENTSCHRIFT

(11) **EP 1 313 581 B1**
(45) Veröffentlichungstag und Bekanntmachung des Hinweises auf die Patenterteilung: **13.12.2006**
(21) Anmeldenummer: 01974159.4
(22) Anmeldetag: 10.08.2001
(51) Int. Cl.: B22F 1/00, B22F 9/22, C22C 1/04

(54) **VERFAHREN ZUR HERSTELLUNG VON VERBUNDBAUTEILEN DURCH PULVER-SPRITZGIESSEN**
METHOD FOR PRODUCING COMPOSITE COMPONENTS BY POWDER INJECTION MOLDING
PROCEDE DE PRODUCTION DE PIECES EN MATERIAU COMPOSITE PAR MOULAGE PAR INJECTION DE POUDRE

(30) Priorität: 23.08.2000 DE 10041194
(43) Veröffentlichungstag der Anmeldung: 28.05.2003
(73) Patentinhaber: H.C. Starck GmbH, 38642 Goslar (DE)
(72) Erfinder: MEINHARDT, Helmut, 79730 Murg (DE); MEYER, Bernd, 79713 Bad Säckingen (DE); KNÜWER, Matthias, 28717 Bremen (DE); FISTER, Dietmar, 79730 Murg (DE); WIEZORECK, Wolfgang, 79725 Laufenburg (DE)
(74) Vertreter: Peters, Frank M.
(86) Internationale Anmeldenummer: PCT/EP2001/009253
(87) Internationale Veröffentlichungsnummer: WO 2002/016063

(56) Entgegenhaltungen:
- EP-A- 0 753 592
- EP-A- 0 774 315
- EP-A- 0 806 489
- EP-A- 1 138 420
- DE-A- 19 962 015
- US-A- 3 382 066
- US-A- 4 988 386
- US-A- 5 950 063
- US-A1- 2001 041 146
- DATABASE WPI Section Ch, Week 7815 Derwent Publications Ltd., London, GB; Class L,Page 03, AN 1978-27489A[15] XP002188188 & JP 53 021014 A (TDK ELECTRONICS CO LTD), 27. Februar 1978 (1978-02-27)
- DATABASE INSPEC [Online] INSTITUTE OF ELECTRICAL ENGINEERS, STEVENAGE, GB; SKOROKHOD V V ET AL: "Solid-phase sintering of ultrafine W(Mo)-Cu composite powders" Database accession no. 2383807 XP002196061 & POROSHKOVAYA METALLURGIYA, JAN. 1984, UKRAINIAN SSR, USSR, Bd. 23, Nr. 1, Seiten 19-25, ISSN: 0032-4795
- DATABASE INSPEC [Online] INSTITUTE OF ELECTRICAL ENGINEERS, STEVENAGE, GB; LANDAU T E ET AL: "Sintering kinetics of finely divided molybdenum-copper composites" Database accession no. 3493880 XP002196062 & POROSHKOVAYA METALLURGIYA, SEPT. 1988, UKRAINIAN SSR, USSR, Bd. 27, Nr. 9, Seiten 13-16, ISSN: 0032-4795
- DATABASE INSPEC [Online] INSTITUTE OF ELECTRICAL ENGINEERS, STEVENAGE, GB; KORNILOVA V I ET AL: "Effect of oxygen on the liquid-phase sintering of very fine tungsten-copper powder mixtures" Database accession no. 2676484 XP002196063 & POROSHKOVAYA METALLURGIYA, MARCH 1985, UKRAINIAN SSR, USSR, Bd. 24, Nr. 3, Seiten 24-26, ISSN: 0032-4795
- DATABASE INSPEC [Online] INSTITUTE OF ELECTRICAL ENGINEERS, STEVENAGE, GB; SEBASTIAN K V ET AL: "Densification in W-Cu sintered alloys produced from coreduced powders" Database accession no. 1140997 XP002196064 & PLANSEEBERICHTE FUR PULVERMETALLURGIE, JUNE 1977, AUSTRIA, Bd. 25, Nr. 2, Seiten 84-100, ISSN: 0032-0765
- MOON I H ET AL: "FULL DENSIFICATION OF LOOSELY PACKED W-CU COMPOSITE POWDERS" POWDER METALLURGY, METALS SOCIETY. LONDON, GB, Bd. 41, Nr. 1, 1998, Seiten 51-57, XP000751997 ISSN: 0032-5899

## Beschreibung

Die vorliegende Erfindung betrifft ein Verfahren zur Herstellung von metallischen und metall-keramischen Verbundbauteilen aus Verbundpulvern, insbesondere auf der Basis von Molybdän-Kupfer und Wolfram-Kupfer durch Pulver-Spritzgießen (Powder Injection Molding; PIM).

Metallische und metall-keramische Verbundwerkstoffe finden als Spezialwerkstoffe beispielsweise im Anlagen-, Apparate- und Gerätebau vielseitige Verwendung. Wolfram-Kupfer- und Molybdän-Kupfer-Verbundwerkstoffe werden aufgrund ihrer vergleichsweise hohen Wärmeleitfähigkeit in verschiedenen elektrischen und elektronischen Anwendungen eingesetzt. Beispielsweise werden solche Werkstoffe in zunehmendem Maße für verschiedene Anwendungen in der Informations-, Kommunikations- und Verkehrstechnik als sogenannte "heat sinks", "heat spreaders" und "packagings" verwendet. Darüber hinaus werden Bauteile aus Verbundwerkstoffen auf der Basis von Wolfram/Molybdän-Kupfer wegen ihrer guten Leitfähigkeit und hohen Verschleißfestigkeit als elektrische Kontakte, Punktschweißelektroden, zum "electro-discharge machining", für Leistungsschalter und als Kommutatorwerkstoff eingesetzt.

Zur Herstellung von Verbundbauteilen sind verschiedene Verfahren bekannt, wobei dem Pulver-Spritzgießen (PIM) eine besondere Bedeutung zukommt. Dabei wird eine geeignete Pulvermischung, die die gewünschten Metalle' und gegebenenfalls weitere Zusätze enthält, mit einem sogenannten Binder vermischt. Diese Mischung wird homogenisiert, verdichtet, entbindert und gesintert.

Die Qualität der erhaltenen Verbundbauteile wird entscheidend von der Qualität und Zusammensetzung des eingesetzten Verbundpulvers bzw. der Verbundpulver-Binder-Mischung beeinflußt. Die Verbundpulver-Binder-Mischung wird auch als Feedstock bezeichnet. Insbesondere bei der Verarbeitung von Verbundpulvern auf der Basis von Wolfram-Kupfer und Molybdän-Kupfer ist es schwierig, Verbundbauteile mit Dichten zu erhalten, die nahe der theoretisch möglichen Dichte liegen. Ebenso problematisch ist es, für die Bauteilabmessungen Toleranzwerte von ± 0,1 % einzuhalten.

US-A-5,993,731 und US-A-5,686,676 sowie EP-A-806489 schlagen vor, Metall-Verbundbauteile, insbesondere Wolfram-Kupfer- und Molybdän-Kupfer-Verbundbauteile durch Metallpulver-Spritzgießen herzustellen, wobei das Bauteil, das dem Sinterprozess unterworfen wird neben Metall auch chemisch gebundenen Sauerstoff, beispielsweise in Form von Metalloxiden, enthält. Sauerstoff muss in ausreichender Menge im Gemisch vorhanden sein, um die Sintereigenschaften des Gemischs zu verbessern. Die Sinterung erfolgt in einer reduzierenden Atmosphäre, wobei der enthaltene Sauerstoff nach und nach bis auf einen technisch möglichen Mindestwert entfernt werden soll. Gemäß der Beispiele lassen sich auf diese Weise Wolfram-Kupfer- und Molybdän-Kupfer-Verbundbauteile mit einer Dichte erhalten, die etwa 98 % der theoretischen Dichte entspricht. Problematisch ist hier jedoch, dass die Verbundbauteile vor der Sinterung noch große Mengen an Sauerstoff in Form von Metalloxiden enthalten. Im Bauteil verbleibender Sauerstoff wird bei der üblichen Flüssigphasen-Sinterung im Kupfergitter gelöst und kann so nachteilig auf die Bauteileigenschaften wirken. Es ist nicht sichergestellt, dass der im Ausgangsgemisch enthaltene Sauerstoff bei diesem Vorgehen nahezu vollständig abgebaut wird und nicht in das Kupfer-Gefüge diffundiert.

US-A-5,905,938 beschreibt ein Verfahren zur Herstellung von Wolfram-Kupfer- und Molybdän-Kupfer-Verbundbauteilen ausgehend von Wolfram- und/oder Molybdän-Pulver mit einer Partikelgröße von bis zu 1 µm und Kupfer-Pulver mit einer Partikelgröße von bis zu 7 µm. Das Kupfer-Pulver kann auch durch Kupferoxid-Pulver ersetzt werden, wobei das Kupferoxid während der Sinterung reduziert werden muss. Zur Verbesserung des Sinterverhaltens müssen Metalle der Eisengruppe (Fe, Co, Ni) und Phosphor zugesetzt werden. Nachteilig an diesem Vorgehen ist, dass wiederum nicht sichergestellt ist, dass das Verbundbauteil weitgehend sauerstofffrei ist. Außerdem wird die Wärmeleitfähigkeit der Kupfer-Matrix schon durch geringe Anteile an Eisen, Kobalt oder Nickel deutlich herabgesetzt.

Aus US-A-5,950,063 und US-A-5,641,920 sind verschiedene Möglichkeiten bekannt, Ausgangsmischungen herzustellen, die für die Weiterverarbeitung durch Pulver-Spritzgießen besonders geeignet sind. So wird vorgeschlagen, die einzelnen Komponenten des Binders in einer inerten Atmosphäre zu vermischen. Auch die Vermischung von Binder und Pulver-System soll in inerter Atmosphäre erfolgen. Dadurch wird verhindert, dass sich Komponenten des Binders mit geringem Molekulargewicht oxidativ zersetzen. Es wird jedoch nicht darauf hingewiesen, dass es vorteilhaft sein könnte, das Pulver-System schon vor dem Vermischen mit dem Binder vor dem Kontakt mit Sauerstoff, insbesondere durch die Zugabe einer Schutzflüssigkeit, zu schützen.

In den beschriebenen Verfahren zur Herstellung von Metall-Verbundbauteilen durch Metallpulver-Spritzgießen werden Metallpulver-Binder-Mischungen verarbeitet, die neben den Metallen auch Sauerstoff enthalten. Die Anwesenheit von Sauerstoff ist problematisch, da sich dieser beim Sintern im Metallgitter lösen kann. Bei Molybdän-Kupfer- und Wolfram-Kupfer-Verbundbauteilen führt der im Kupfergitter gelöste Sauerstoff zu einer unerwünschten Abnahme der Wärmeleitfähigkeit.

Die Aufgabe der vorliegenden Erfindung bestand darin, ein Verfahren zur Herstellung von metallischen und metall-keramischen Verbundbauteilen, insbesondere auf Basis von Molybdän-Kupfer und Wolfram-Kupfer durch Pulver-Spritzgießen zur Verfügung zu stellen, mit dem Verbundpulver in einfacher Weise zu hochwertigen Produkten umgesetzt werden können. Weiterhin war es Aufgabe, Verbundpulver auf Basis von Molybdän-Kupfer und Wolfram-Kupfer zur Verfügung zu stellen, die sich besonders zur Verarbeitung mittels Pulver-Spritzgußverfahren eignen.

Die Erfindung betrifft ein Verfahren zur Herstellung von Verbundbauteilen durch Pulver-Spritzgießen eines Systems enthaltend ein Metall-Verbundpulver und einen Binder, das dadurch gekennzeichnet ist, dass das Metall-Verbundpulver vor dem Vermischen mit dem Binder in einer inerten Atmosphäre mit einer Schutzflüssigkeit vermengt wird.

In einer besonderen Ausgestaltung des erfindungsgemäßen Verfahrens wird dem Metall-Verbundpulver eine Keramik-Komponente zugesetzt. Die Zugabe der Keramik-Komponente kann vor oder nach dem Vermengen mit der Schutzflüssigkeit erfolgen. Bei den entstehenden Verbundbauteilen handelt es sich dann um Metall-Keramik-Verbundbauteile.

Des Weiteren ist ein Verfahren zur Herstellung von Verbundbauteilen Gegenstand der Erfindung, das folgende Schritte umfasst:
a) Erzeugung eines Metall-Verbundpulvers durch Reduktion von Oxiden mindestens zweier verschiedener Metalle mit Wasserstoff,
b) Vermengen des Metall-Verbundpulvers in einer inerten Atmosphäre mit einer Schutzflüssigkeit,
c) gegebenenfalls Zugabe einer Keramik-Komponente,
d) Vermischen des Produkts mit einem Binder,
e) Spritzgießen der erhaltenen Verbundpulver-Binder-Mischung.

Gegebenenfalls können im Schritt a) nicht nur die Oxide der Metalle reduziert werden, aus denen sich das gewünschte Verbundbauteil im Wesentlichen zusammensetzt, sondern gleichzeitig weitere Metallverbindungen, deren Metallkomponente bei der späteren Weiterverarbeitung zum Verbundbauteil als Sinteradditiv wirkt.

Der Wassergehalt des eingesetzten Wasserstoffs sollte so niedrig wie möglich sein.

Es muss beim erfindungsgemäßen Verfahren darauf geachtet werden, dass das Metall-Verbundpulver vom Zeitpunkt seiner Herstellung an bis zu dem Zeitpunkt, an dem die Vermengung mit der Schutzflüssigkeit erfolgt ist, weitgehend vor Kontakt mit Sauerstoff geschützt ist.

Das erfindungsgemäße Verfahren zeichnet sich dadurch aus, dass auf überraschend einfache Weise metallische und metall-keramische Verbundbauteile erhalten werden, die einen sehr geringen Gehalt an im Metallgitter gelöstem Sauerstoff aufweisen. Auch ohne Zugabe von Sinter-Additiven lassen sich hohe Bauteildichten und damit auch sehr gute mechanische Bauteileigenschaften erhalten. Die Sinterung kann bei vergleichsweise niedrigen Temperaturen erfolgen, wodurch die Gefahr verringert wird, dass sich das Bauteil während des Sintervorgangs verformt. Dadurch lassen sich sehr enge Toleranzwerte für die Bauteilgeometrie einhalten.

Im erfindungsgemäßen Verfahren können eine Vielzahl von Metall-Verbundpulvern eingesetzt werden, die zwei oder mehr verschiedene Metalle enthalten. Beispielsweise eignen sich Metall-Verbundpulver, die zum einen ein oder mehrere Metalle der Gruppe Kupfer, Nickel, Eisen, Chrom, Zink, Zinn, Beryllium, Antimon, Titan, Silber, Kobalt, Aluminium, Rhenium und Niob und zum anderen ein oder mehrere Metalle der Gruppe Wolfram, Molybdän, Tantal enthalten. Weitere Elemente, z.B. Bor oder Silicium oder Element-Kombinationen sind durch diese Aufzählung nicht ausgeschlossen. Die Elemente können teilweise auch in Form von Nanopulvern vorliegen, beispielsweise als Pulver mit einem mittleren Teilchendurchmesser < 100 nm.

Bevorzugt werden solche Metall-Verbundpulver eingesetzt, die einerseits ein oder mehrere Metalle der Gruppe Kupfer, Nickel, Eisen und Kobalt und andererseits Molybdän und/oder Wolfram enthalten, besonders bevorzugt solche, die einerseits Kupfer und andererseits Molybdän und/oder Wolfram enthalten.

Insbesondere bevorzugt werden Molybdän-Kupfer- und Wolfram-Kupfer-Verbundpulver eingesetzt, die eine Metall-Primärkorngröße überwiegend <2 µm und einen Sauerstoffgehalt <0,8 Gew.-%, vorzugsweise <0,5 Gew.-%, besonders bevorzugt <0,3 Gew.-% aufweisen. Vorzugsweise weisen mindestens 90 % der Metall-Primärkömer eine Größe <2 µm auf, wobei die Metall-Primärkorngröße mittels Bildanalyse einer rasterelektronenmikroskopischen Aufnahme des Verbundpulvers ermittelt wird.

Bei Verwendung dieser Molybdän-Kupfer- bzw. Wolfram-Kupfer-Verbundpulver können komplex geformte Bauteile mit besonders hoher Dichte und Maßtoleranz erhalten werden. Dies gilt insbesondere bei Anwesenheit sinterfördernder Metallzusätze und stabiler Keramikpartikel, da die anwesenden Keramikpartikel zum Abbau innerer Spannungen und somit zusätzlich zur Verminderung des Verzugs solcher Bauteile beitragen.

Ein weiterer Vorteil der Verwendung solcher Molybdän-Kupfer- oder Wolfram-Kupfer-Verbundpulver besteht darin, dass das Sintern bei relativ niedrigen Temperaturen erfolgen kann, beispielsweise bei Temperaturen von 1090 bis 1 300°C. Dies wird vor allem durch den geringen Sauerstoffgehalt, aber auch durch die geringe Partikelgröße der metallischen Anteile ermöglicht.

Trotz der niedrigen Sintertemperatur zeichnen sich die erhaltenen Verbundbauteile durch eine hervorragende Mikrohomogenität und Dichte aus. Vorzugsweise beträgt die Dichte >98 %.

Als geeignete Keramik-Komponenten zur Herstellung metall-keramischer Verbundwerkstoffe seien beispielsweise Boride, etwa Titanborid, Oxide, wie z.B. Nioboxid, Titanoxid und Aluminiumoxid, Nitride, z.B. Aluminiumnitrid und Siliciumnitrid, Carbide und Silizide genannt, wobei jedoch auch andere Keramik-Komponeten möglich sind. Die Keramik-Komponente kann einen einzelnen Bestandteil, aber auch beliebige Gemische verschiedener Bestandteile umfassen. Die Bestandteile der Keramik-Komponente können auch in Form von Nano-Pulvern vorliegen.

Bevorzugt wird als Keramik-Komponente Aluminiumnitrid verwendet, insbesondere Aluminiumnitrid-Pulver mit einem mittlerem Teilchendurchmesser von < 10 µm.

Der Sauerstoff, der in Form oxidischer Keramik-Komponenten in das gewünschte metall-keramische Verbundbauteil eingebracht wird, ist im Gegegnsatz zu dem Sauerstoff, der über die metallischen Anteile eingebracht wird, unkritisch und wandert bei der Sinterung nicht in das Gitter der Metallkomponente des Verbundbauteils, da nur oxidische Keramik-Komponenten eingesetzt werden, die bei den üblichen Sintertemperaturen thermodynamisch stabil sind.

Oxidische Keramik-Komponenten können dem Metall-Verbundpulver schon während dessen Herstellung zugesetzt werden. Vorteilhaft wird die Keramik-Komponente dem Metall-Verbundpulver jedoch nach dessen Herstellung zugemischt.

Erfindungsgemäß wird das Verbundpulver in einer inerten Atmosphäre, beispielsweise in Gegenwart von Argon und/oder Stickstoff mit einer Schutzflüssigkeit versetzt. Unter Schutzflüssigkeit wird dabei eine Flüssigkeit verstanden, die das Verbundpulver bei dessen weiterer Verarbeitung vor dem Kontakt mit Sauerstoff schützt und für den später zuzumischenden organischen Binder nicht schädlich ist.

Sollen metall-keramische Verbundbauteile hergestellt werden, ist es möglich, dem Metall-Verbundpulver zunächst die Keramik-Komponente zuzumischen und dann das entstehende Metall-Keramik-Verbundpulver mit der Schutzflüssigkeit zu behandeln. Vorzugsweise wird jedoch das Metall-Verbundpulver zunächst mit der Schutzflüssigkeit versetzt und erst anschließend die Keramik-Komponente zugegeben.

Geeignete Schutzflüssigkeiten sind beispielsweise organische Lösungsmittel, in denen Sauerstoff sehr schlecht löslich ist. Beispielhaft seien Hexan, Heptan, Toluol und Gemische davon genannt. Bevorzugt wird dem organischen Lösungsmittel eine in dem Lösungsmittel lösliche Wachskomponente zugesetzt. Bei einer später erfolgenden Verdampfung der Schutzflüssigkeit werden die Bedingungen vorzugsweise so gewählt, dass die Wachskomponente zurückbleibt und einen dichten Schutzfilm auf dem Verbundpulver bildet. Dadurch, dass die Wachskomponente zunächst in gelöster Form vorliegt, werden auch kleine Zwischenräume und Poren des Verbundpulvers von der Schutzflüssigkeit ausgefüllt. Auch hier kann sich folglich beim Verdampfen der Schutzflüssigkeit ein dichter Schutzfilm aus der zugesetzten Wachskomponente bilden.

Bei der Wachskomponente kann es sich beispielsweise um einen in dem eingesetzten organischen Lösungsmittel löslichen Bestandteil des später verwendeten Binders handeln. Beispielhaft seien als geeignete Wachskomponente Paraffin, Bienenwachs, und Carnaubawachs genannt.

Die Menge der eingesetzten Schutzflüssigkeit ist nur insofern kritisch, als gewährleistet sein muss, dass die Oberfläche der Partikel des Verbundpulvers mit der Schutzflüssigkeit bedeckt ist.

Durch die Zugabe der Schutzflüssigkeit wird eine Sauerstoffaufnahme des Verbundpulvers verhindert, die die Sinteraktivität deutlich herabsetzen könnte. Darüber hinaus wird eine mögliche Agglomeration des Verbundpulvers, die zu einer unerwünschten Porenbildung im daraus hergestellten Verbundbauteil führen würde, weitgehend unterdrückt.

Das Gemisch aus Verbundpulver und Schutzflüssigkeit wird erfindungsgemäß mit einem Binder, insbesondere einem pulverförmigen Binder versetzt.

Geeignete Binder sind dem Fachmann bekannt. Es handelt sich in der Regel um mehrkomponentige, organische Systeme, beispielsweise auf Polyethylenwachsbasis. Als Binder werden technisch vor allem thermoplastische Binder eingesetzt. Thermoplastische Binder enthalten beispielsweise in unterschiedlichen Konzentrationen als Hauptbestandteil Paraffin, Camaubawachs, Bienenwachs, Polyethylenwachs und/oder pflanzliche Öle, als Thermoplast Polyethylen, Polypropylen, Polystyrol und/oder Polyamid und als Additive Stearin- und Ölsäure und ihre Ester und/oder Phthalsäureester. Daneben werden technisch beispielsweise auch duroplastische und gelierende Binder verwendet.

Die Zugabe des Binders dient in erster Linie der Formgebung beim Pulverspritzgießen. Nur der Anteil des Binders mit dem höchsten Schmelzpunkt ist für den Zusammenhalt der Verbundpulver-Binder-Mischung vor Sinterbeginn erforderlich.

Vorteilhaft erfolgt die Vermischung von Binder und dem Gemisch aus Verbundpulver und Schutzflüssigkeit bei Temperaturen von 100°C bis 200°C. Während dieses Vorgangs verdampft die Schutzflüssigkeit oder wird in den Binder integriert.

Der Mischvorgang kann ohne Anwesenheit von Schutzgas durchgeführt werden, da die Schutzflüssigkeit einen unerwünschten Kontakt des Verbundpulvers mit Sauerstoff verhindert. Der Einsatz von Schutzgas bei diesem Vorgang ist jedoch nicht ausgeschlossen.

Der Mischvorgang kann beispielsweise in geeigneten Knetvorrichtungen durchgeführt werden.

Die erhaltene Verbundpulver-Binder-Mischung (Feedstock) kann in an sich bekannter Weise zur Herstellung von Verbundbauteilen durch Pulver-Spritzgießen weiter umgesetzt werden. Beispielsweise kann der Feedstock in einem geeigneten Gerät, beispielsweise einem Kneter oder Extruder vorhomogenisiert werden. Anschließend können durch Verwendung eines Scherwalzenextruders mögliche Agglomerate im Feedstock weitgehend zerstört und die notwendige gute Mikrohomogenität des Feedstocks eingestellt werden. Aus der so vorbehandelten Verbundpulver-Binder-Mischung kann in an sich bekannter Weise ein Granulat erzeugt werden, das durch Verdichten, Entbindern und Sintern in ein Verbundbauteil überführt werden kann.

Enthält die Verbundpulver-Binder-Mischung Aluminium, so wird dieses bei entsprechender Sinteratmosphäre, d.h. bei Sinterung in einer Stickstoffatmosphäre zu Aluminiumnitrid umgesetzt. In diesem Fall entsteht also beim Sintern eine Keramik-Komponente.

Molybdän-Kupfer- und Wolfräm-Kupfer-Verbundpulver, die eine Metall-Primärkorngröße von überwiegend <2 µm und einen Gehalt an im Metallgitter gelöstem Sauerstoff <0,8 Gew.-% aufweisen, zeichnen sich durch eine hohe Sinteraktivität aus und eignen sich daher ausgezeichnet zur Herstellung von Verbundbauteilen nach dem bereits beschriebenen erfmdungsgemäßen Verfahren. Ein weiterer Vorteil besteht darin, dass die Verbundpulver weitgehend frei von Agglomeraten sind.

Vorzugsweise weisen mindestens 90% der Metall-Primärkömer der eingesetzten Verbundpulver eine Größe <2 µm auf, wobei die Metall-Primärkorngröße mittels Bildanalyse einer rasterelektronenmikroskopischen Aufnahme des Verbundpulvers ermittelt wird.

Vorzugsweise weisen diese Verbundpulver einen Gehalt an im Metallgitter gelöstem Sauerstoff<0,5 Gew.-%, insbesondere bevorzugt <0,3 Gew.-% auf.

Gegebenenfalls enthalten die eingesetzten Molybdän-Kupfer- und Wolfram-Kupfer-Verbundpulver eine Keramik-Komponente. Als Keramik-Komponente eignen sich beispielsweise solche Bestandteile, die bereits oben angeführt sind.

Das Gewichts-Verhältnis von Molybdän/Wolfram zu Kupfer kann in weiten Bereichen variieren und beträgt beispielsweise von 90:10 bis 10:90, vorzugsweise von 90:10 bis 30:70, besonders bevorzugt von 90:10 bis 50:50.

Ist eine Keramik-Komponente zugegen, beträgt das Gewichts-Verhältnis von Molybdän/Wolfram zu Kupfer beispielsweise von 90:10 bis 10:90, vorzugsweise von 90:10 bis 30:70, besonders bevorzugt von 90:10 bis 50:50 und der Gewichts-Anteil von Keramik-Komponenten im Metall-Keramik-Verbundpulver beispielsweise 0,1 - 40 Gew.-%, vorteilhaft 1 - 10 Gew.-%.

Zur Herstellung des bevorzugt eingesetzten Molybdän/Wolfram-Kupfer-Verbundpulvers kann beispielsweise von Oxiden des Molybdäns bzw. Wolframs, z. B. MoO₂ bzw. WO₃, und des Kupfers, z.B. CuO ausgegangen werden. Die Oxide werden trocken gemahlen, um eine möglichst kleine Partikelgröße zu erzielen. Vorteilhaft erfolgt die Mahlung in einer Fließbett-Gegenstrahlmühle. Dadurch werden Verunreinigungen durch Abrieb von Mahlkugeln oder Gehäusewänden vermieden. Nach dem Mahlen werden die Oxide beispielsweise trocken gemischt und in an sich bekannter Weise homogenisiert.

Die homogenisierte Mischung wird in Gegenwart von Wasserstoff bei 800 - 1 050°C, vorzugsweise bei 850 - 950°C reduziert, wodurch der Sauerstoffgehalt auf die erfindungsgemäße Menge verringert wird.

Anschließend kann gegebenenfalls die gewünschte Keramik-Komponente zugemischt werden. Es ist jedoch auch möglich, die Keramik-Komponente bereits vor Herstellung des Molybdän-Kupfer- bzw. des Wolfram-Kupfer-Verbundpulvers zuzusetzen.

Die folgenden Beispiele dienen der weiteren Erläuterung des erfindungsgemäßen Verfahrens, die Erfindung ist jedoch nicht auf die Beispiele beschränkt.

### Beispiele

### Beispiel 1

Zur Herstellung eines Molybdän-Kupfer-Verbundpulvers bzw. Feedstocks mit einem Gewichts-Verhältnis von Mo:Cu = 70:30 wurde eine Mischung aus 71 Gew.-% MoO₂ und 29 Gew.-% CuO trocken in der Gegenstrahlmühle gemahlen und anschließend bei 850°C unter trockenem Wasserstoff reduziert. Der Gesamt-Sauerstoffgehalt betrug 0,40 Gew.-%. 2 000 g des Molybdän-Kupfer-Verbundpulvers wurden anschließend unter Stickstoff in 650 ml Hexan eingerührt, dem 50 g Paraffinwachs zugefügt waren. Als Binder zur Herstellung des Feedstocks wurde im beheizbaren Sigma-Kneter ein Wachs-Polymer-Gemisch hinzugefügt. Die Temperatur wurde während der nachfolgenden vorläufigen Homogenisierung auf 140°C erhöht, wobei das als Schutzflüssigkeit zunächst zugesetzte Hexan verdampfte. Das Hexan wurde recycliert. Der vorhomogenisierte Feedstock wurde dann auf einem Scherwalzenextruder bis zur erforderlichen Mikrohomogenität weiterverarbeitet.

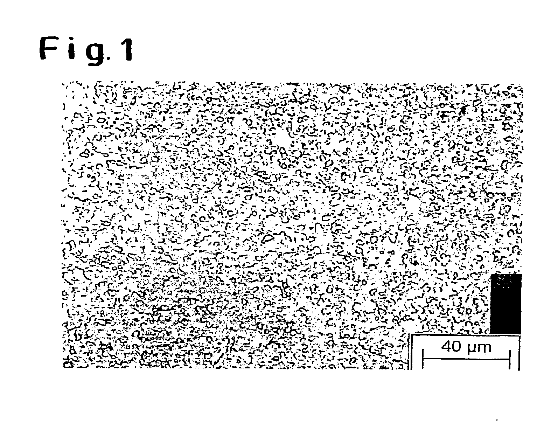

Der so erhaltene Feedstock wurde durch Metallpulver-Spritzgießen zu Proben verarbeitet. Dabei wurden an der Spritzgussmaschine die Parameter Temperatur, Einspritzzeit, Einspritzgeschwindigkeit und -druck sowie die Werkzeugtemperatur optimiert. Die erhaltenen Proben wurden nasschemisch und thermisch entbindert und anschließend in reduzierender Atmosphäre gesintert. Das Gefüge dieser Proben (Figur 1) ist nahezu vollständig dicht und zeigt eine für die Feinheit des Molybdän-Pulvers (dunkle Phase) sehr gute Mikrohomogenität. Kupfer (helle Phase) umschließt die überwiegend < 2 µm Molybdän-Partikel.

### Beispiel 2

Eine Mischung aus 80 Gew.-% WO₃ und 20 Gew.-% CuO wurde trocken in der Gegenstrahlmühle gemahlen und anschließend bei 850°C unter trockenem Wasserstoff reduziert. Auf diese Weise wurde ein Wolfram-Kupfer-Verbundpulver mit einem Gewichts-Verhältnis von Wolfram zu Kupfer von 80 zu 20 erhalten. 2 000 g des Wolfram-Kupfer-Verbundpulvers wurden anschließend unter Stickstoff in 650 ml Hexan eingerührt, dem 50 g Paraffinwachs zugefügt waren. Bei dieser Vermischung wurden 40 g Aluminiumnitrid-Pulver (H.C. Starck, Grade C) zugefügt. Zur Herstellung des Feedstocks wurde dann als Binder im beheizbaren Sigma-Kneter ein Wachs-Polymer-Gemisch hinzugefügt. Die Temperatur wurde während der nachfolgenden vorläufigen Homogenisierung auf 140°C erhöht, wobei das als Schutzflüssigkeit zunächst zugesetzte Hexan verdampfte. Das Hexan wurde recycliert. Der vorhomogenisierte Feedstock wurde dann auf einem Scherwalzenextruder bis zur erforderlichen Mikrohomogenität weiterverarbeitet.

Der so erhaltene Feedstock wurde wie in Beispiel 1 zu Proben verarbeitet, die ein Gefüge aufweisen, das nahezu vollständig dicht ist und eine für die Feinheit des Wolfram-Pulvers sehr gute Mikrohomogenität zeigt.

## Patentansprüche

1. Verfahren zur Herstellung von Verbundbauteilen durch Pulver-Spritzgießen eines Systems enthaltend ein Metall-Verbundpulver und einen Binder, **dadurch gekennzeichnet, dass** das Metall-Verbundpulver vor dem Vermischen mit dem Binder in einer inerten Atmosphäre mit einer Schutzflüssigkeit vermengt wird, die das Verbundpulver bei dessen weiterer Verarbeitung vor dem Kontakt mit Sauerstoff schützt.

2. Verfahren nach Anspruch 1, **dadurch gekennzeichnet, dass** das System enthaltend ein Metall-Verbundpulver und einen Binder zusätzlich eine Keramik-Komponente aufweist.

3. Verfahren zur Herstellung von Verbundbauteilen, das folgende Schritte umfasst:
a) Erzeugung eines Metall-Verbundpulvers durch Reduktion von Oxiden mindestens zwei verschiedener Metalle mit Wasserstoff,
b) Vermengen des Metall-Verbundpulvers in einer inerten Atmosphäre mit einer Schutzflüssigkeit, die das Verbundpulver bei dessen weiterer Verarbeitung vor dem Kontakt mit Sauerstoff schützt,
c) gegebenenfalls Zugabe einer Keramik-Komponente,
d) Vermischen des Produkts mit einem Binder,
e) Pulver-Spritzgießen der erhaltenen Verbundpulver-Binder-Mischung.

4. Verfahren nach wenigstens einem der Ansprüche 1 bis 3, **dadurch gekennzeichnet, dass** als Schutzflüssigkeit Hexan, Heptan, Toluol oder deren Gemische verwendet werden.

5. Verfahren nach wenigstens einem der Ansprüche 1 bis 4, **dadurch gekennzeichnet, dass** die Schutzflüssigkeit eine Wachskomponente enthält.

6. Verfahren nach wenigstens einem der Ansprüche 1 bis 5, **dadurch gekennzeichnet, dass** es sich bei den Verbundbauteilen um Wolfram-Kupfer-Verbundbauteile oder um Molybdän-Kupfer-Verbundbauteile handelt.

7. Verfahren nach Anspruch 6, **dadurch gekennzeichnet, dass** der im Rahmen des Pulver-Spritzgießens erforderliche Sinterschritt bei einer Sinterteinperatur von 1 090 bis 1 300°C durchgeführt wird.

8. Verfahren nach wenigstens einem der Ansprüche 1 bis 7, **dadurch gekennzeichnet, dass** das Metall-Verbundpulver eine Metall-Primärkorngröße überwiegend <2 µm und einen Sauerstoffgehalt <0,8 Gew.-% aufweist.

## Claims

1. A process for preparing composite components by powder injection moulding of a system containing a metal composite powder and a binder, **characterised in that**, before blending with the binder, the metal composite powder is mixed in an inert atmosphere with a protective liquid that protects the composite powder from contact with oxygen during the further processing thereof.

2. A process according to claim 1, **characterised in that** the system containing a metal composite powder and a binder also has a ceramic component.

3. A process for producing composite components that comprises the following steps:
a) producing a metal composite powder by reducing the oxides of at least two different metals with hydrogen,
b) mixing the metal composite powder in an inert atmosphere with a protective liquid that protects the composite powder from contact with oxygen during the further processing thereof,
c) optionally adding a ceramic component,
d) blending the product with a binder,
e) powder injection moulding the composite powder/binder mixture.

4. A process according to at least one of claims 1 to 3, **characterised in that** hexane, heptane, toluene or mixtures thereof are used as protective liquids.

5. A process according to at least one of claims 1 to 4, **characterised in that** the protective liquid contains a wax component.

6. A process according to at least one of claims 1 to 5, **characterised in that** the composite components are tungsten/copper composite components or molybdenum/copper composite components.

7. A process according to claim 6, **characterised in that** the sintering step required in the context of powder injection moulding is performed at a sintering temperature of 1090 to 1300°C.

8. A process according to at least one of claims 1 to 7, **characterised in that** the metal composite powder has a primary metal particle size of mainly <2 µm and an oxygen content <0.8 wt.%.

## Revendications

1. Procédé pour la fabrication de pièces de construction composites par moulage de poudre par injection à partir d'un mélange contenant une poudre métallique composite et un liant, **caractérisé en ce que** la poudre métallique composite, avant son mélange avec le liant, est mélangée en atmosphère inerte avec un liquide protecteur qui la protège contre un contact avec l'oxygène au cours des opérations consécutives.

2. Procédé selon la revendication 1, **caractérisé en ce que** le mélange contenant une poudre métallique composite et un liant contient en outre un composant céramique.

3. Procédé pour la fabrication de pièces de construction composites, qui comprend les stades opératoires suivants :
a) préparation d'une poudre métallique composite par réduction d'oxydes d'au moins deux métaux différents par l'hydrogène,
b) mélange de la poudre métallique composite, en atmosphère inerte, avec un liquide protecteur qui la protège contre un contact avec l'oxygène lors des opérations consécutives,
c) le cas échéant addition d'un composant céramique,
d) mélange du produit avec un liant,
e) moulage du mélange poudre composite-liant ainsi obtenu par injection de poudre.

4. Procédé selon au moins l'une des revendications 1 à 3, **caractérisé en ce que** le liquide protecteur utilisé est l'hexane, l'heptane, le toluène ou un mélange de ceux-ci.

5. Procédé selon au moins une des revendications 1 à 4, **caractérisé en ce que** le liquide protecteur contient un composant cireux.

6. Procédé selon au moins une des revendications 1 à 5, **caractérisé en ce que** les pièces de construction composites sont des pièces de tungstène-cuivre ou des pièces de molybdène-cuivre.

7. Procédé selon la revendication 6, **caractérisé en ce que** l'opération de frittage nécessaire dans le cadre du moulage de poudre par injection est réalisée à une température de 1090 à 1300°C.

8. Procédé selon au moins une des revendications 1 à 7, **caractérisé en ce que** la poudre métallique composite a une dimension de grain métallique primaire majoritairement inférieure à 2 µm et a une teneur en oxygène inférieure à 0,8 % en poids.
